# EUROPEAN PATENT SPECIFICATION

(11) **EP 0 599 730 B1**
(45) Date of publication and mention of the grant of the patent: **16.06.1999**
(21) Application number: 93402843.2
(22) Date of filing: 23.11.1993
(51) Int. Cl.: H01L 21/316, H01L 21/768, C23C 16/40

(54) **Semiconductor device and method of producing the same**
Halbleiteranordnung und Herstellungsverfahren dafür
Composant semi-conducteur et son procédé de fabrication

(30) Priority: 24.11.1992 JP 31372092; 25.03.1993 JP 6711693
(43) Date of publication of application: 01.06.1994
(73) Proprietor: SUMITOMO METAL INDUSTRIES, LTD., Osaka-shi, Osaka (JP)
(72) Inventor: Fukada, Takashi, Hyogo 663 (JP)
(74) Representative: Bertrand, Didier

(56) References cited:
- EP-A- 0 496 543
- EP-A- 0 517 548
- DATABASE WPI Derwent Publications Ltd., London, GB; AN 87-026696 & JP-A-61 284 578 (SEMICONDUCTOR ENERGY LAB)
- PATENT ABSTRACTS OF JAPAN vol. 17, no. 672 (E-1474) 10 December 1993 & JP-A-05 226 480 (NEC CORP) 3 September 1993
- PATENT ABSTRACTS OF JAPAN vol. 9, no. 310 (E-364) 6 December 1985 & JP-A-60 144 940 (HANDOUTAI ENERUGII KENKYUSHO)
- PATENT ABSTRACTS OF JAPAN vol. 17, no. 431 (E-1411) 10 August 1993 & JP-A-05 090 249 (NEC CORP) 9 April 1993

## Description

### Field of the Invention

The invention relates to a semiconductor device having an Si oxide film which is formed by plasma CVD (chemical vapor deposition) with the use of a silicon fluoride gas, and also to a method of producing the semiconductor device.

### Description of the Related Art

Insulating films used in an LSI or a VLSI include a capacitor insulating film, an interlayer dielectric film, and a passivation film. Among these insulating films, the interlayer dielectric film is often formed by a plasma CVD with the use of SiH₄, O₂ or N₂O because a plasma CVD hardly develops defects such as pinholes, or cracks in an insulating film.

However, the reactivity of SiH₄ with O₂ or N₂O is so high that, when they are merely mixed with each other, SiH₄ explosively reacts with O₂ or N₂O. When activated by a plasma, SiH₄ reacts with O₂ or N₂O even more easily. When an Si oxide film is formed by a plasma CVD, therefore, a phenomenon, that a reactant is deposited on portions other than a semiconductor, for example, on an inner wall of a chamber on which an Si oxide film is formed, takes place. This deposit causes particles to be generated, thereby producing a problem in that a resultant semiconductor device is degraded in quality. In order to prevent particles from being generated, it is required to frequently clean the inside of the chamber. This causes another problem in that the working ratio of the apparatus is impaired so that the production yield of semiconductor devices is lowered.

In order to solve these problems, a method has been proposed in which an Si oxide film is formed with the use of a silicon fluoride gas having a reactivity less than that of SiH₄ (J. Appl. Phys. 64(8), 15 Oct. 1988). In the proposed method, a film is grown by a photo CVD using Si₂F₆, O₂ and Si₂H₆ as source gasses. The reactivities of these gasses are slightly lower, and the amount of a reactant deposited on an inner wall of a chamber is reduced. Since the film growth cannot be accomplished with the use of only Si₂F₆ and O₂, however, it is required to use also Si₂H₆ which is highly reactive. Also in the proposed method, therefore, there is the problem that a strong reaction occurs.

When an interlayer dielectric film is to be formed, the planarizability plays an important role. In the case where an interlayer dielectric film is formed so as to cover fine patterns of a wiring gap of 0.5 µm or less, a void is produced, or a defect such as a space is produced by that a portion between adjacent wirings is covered with an insulating film deposited on edges of the wirings and the insulating film does not fill the portion between the wirings sufficiently. This produces a problem in that the planarizability is impaired.

Recently, with the object of increasing the operation speed of a semiconductor device, particularly, an LSI, it is requested to use an Si oxide film having a lower dielectric constant as an interlayer dielectric film for an Al wiring and a passivation film, so that the time constant of the signal transmission through an Al wiring is reduced. In a conventional oxide film CVD such as a photo CVD, a thermal CVD, or a plasma CVD which uses, for example, SiH₄ and O₂, SiH₄ and N₂O, or TEOS, O₃ and O₂, a resulting Si oxide film has a dielectric constant of 3.8 or higher. This high dielectric constant is a main cause of impeding the increase of the operation speed of an LSI. It is considered a phenomenon that the OH content in an Si oxide film is high is originated in the high dielectric constant.

An Si oxide film containing fluorine which is formed by a thermal CVD with the use of a source gas containing alkoxyfluorosilane as the main component is proposed (Japanese Patent Application Laid-Open HEI4-239750 (1992)). The Si oxide film has a dielectric constant of 3.7 which is a mere decrease of less than 10 % from the value of the prior art. The value of the dielectric constant changes depending on the film growth temperature. Since the film contains OH, there arises a problem in that the reliability is low in the case where it is used as an interlayer dielectric film.

A method of forming a gate insulating film of an insulated gate type field effect transistor by a plasma CVD with the use of a gas of a monosilane derivative containing chlorine such as dichlorosilane (SiH₂Cl₂) or a gas of a monosilane derivative containing fluorine is proposed (Japanese Patent Application Laid-Open HEI3-36767 (1991)). This proposal is directed to the improvement of the breakdown strength and the reduction of the interface state density in the formation of an Si oxide film on polysilicon which are problems in a conventional thermal oxidation and a CVD. In the proposed method, the proportion of the monosilane derivative gas containing an element such as chlorine or fluorine or that of hydrogen chloride is increased when the film is to be grown, so that the film growth is conducted while removing from a silicon layer contaminants such as a native oxide film, organic substances and metals. The publication does not mention an Si oxide film containing fluorine.

On the contrary, the publication states that, when a gas of a monosilane derivative such as dichlorosilane or a mixture of hydrogen chloride and monosilane is used, the quantity of chlorine or fluorine contained in the film is reduced by increasing the proportion of the monosilane gas, thereby forming an oxide film which has a high breakdown strength and which is excellent in quality. The publication suggests that the film containing chlorine or fluorine is not preferable.

### SUMMARY OF THE INVENTION

The invention has been devised in order to solve the above-mentioned problems. It is an object of the invention to provide a semiconductor device and a method of producing the semiconductor device in which an Si oxide film is formed by a plasma CVD with the use of a silicon compound gas containing fluorine, whereby particles can be prevented from being generated so that the quality of the produced device and the yield thereof are improved, the planarity of the Si oxide film functioning as an interlayer dielectric film or a passivation film can be improved, and the higher speed operation in a semiconductor device can be accomplished.

According to the invention, in a semiconductor device and a method of producing the same, an Si oxide film containing 0.1 to 20 atom.% of fluorine is formed by plasma CVD with the use of a silicon compound gas which contains fluorine, and O₂ or N₂O. Therefore, the Si oxide film is deposited on a substrate under a reaction milder than that of the prior art. Accordingly, the reaction does not proceed in a portion other than the plasma generating portion, so that the reactant adhesion to the wall of a production apparatus is reduced in degree and the generation of particles is reduced. The thus deposited Si oxide film has a very small content of OH or no OH, contains 0.1 to 20 atom.% of fluorine, and has a dielectric constant of 3.7 to 2.9. Therefore, the signal transmission in the semiconductor device can be conducted at a high speed. When the signal transmission speed of the semiconductor device is set to be the same level as that of the prior art, the thickness of the Si oxide film can be made thinner. Since a fluorine species generated in a plasma easily migrate, the covering property with respect to concave portions of the surface of a substrate is improved.

The semiconductor device of the invention is defined in claim 1.

A method of producing the semiconductor device according to the invention is defined in claim 3.

The above and further objects and features of the invention will more fully be apparent from the following detailed description with accompanying drawings.

### BRIEF DESCRIPTION OF THE DRAWINGS

Fig. 1 is a schematic longitudinal section view showing the configuration of an ECR plasma CVD apparatus which is used in a first embodiment of the invention;
Fig. 2 shows the infrared absorption spectrum of an Si oxide film according to the first embodiment;
Fig. 3 shows the infrared absorption spectrum of an Si oxide film according to the first embodiment;
Fig. 4 is a graph showing the SiF₄ dependence of the dielectric constant of an Si oxide film according to the first embodiment;
Fig. 5 is a graph showing the breakdown strength of an Si oxide film according to the first embodiment;
Fig. 6 is a graph showing the dielectric constant with respect to the quantity of fluorine in an Si oxide film according to a second embodiment;
Fig. 7 is a graph showing the BHF etch rate with respect to the quantity of fluorine in an Si oxide film according to the second embodiment;
Fig. 8 is a schematic section view of an Si oxide film according to a third embodiment;
Fig. 9 is a schematic longitudinal section view showing the configuration of an ECR plasma CVD apparatus which is used in a fourth embodiment;
Fig. 10 is a graph showing the SiF₄ flow rate dependence of the dielectric constant of an Si oxide film according to the fourth embodiment;
Fig. 11 is a graph showing the breakdown strength of an Si oxide film according to the fourth embodiment;
Figs. 12(a) and 12(b) are schematic section views of an Si oxide film according to the fourth embodiment;
Fig. 13 is a schematic section view of an Si oxide film of a prior art example;
Fig. 14 is a schematic section view of a semiconductor device produced by a method of a fifth embodiment;
Fig. 15 is a schematic section view of another semiconductor device produced by the method of the fifth embodiment;
Fig. 16 is a schematic section view of a further semiconductor device produced by the method of the fifth embodiment;
Fig. 17 is a schematic longitudinal section view showing the configuration of an ECR plasma CVD apparatus which is used in a sixth embodiment;
Fig. 18 is a schematic section view of a semiconductor device produced by a method of the sixth embodiment; and
Fig. 19 is a schematic section view of a semiconductor device produced by a method of a seventh embodiment.

### DESCRIPTION OF THE PREFERRED EMBODIMENTS

Hereinafter, the invention will be described with reference to the drawings illustrating the embodiments thereof.

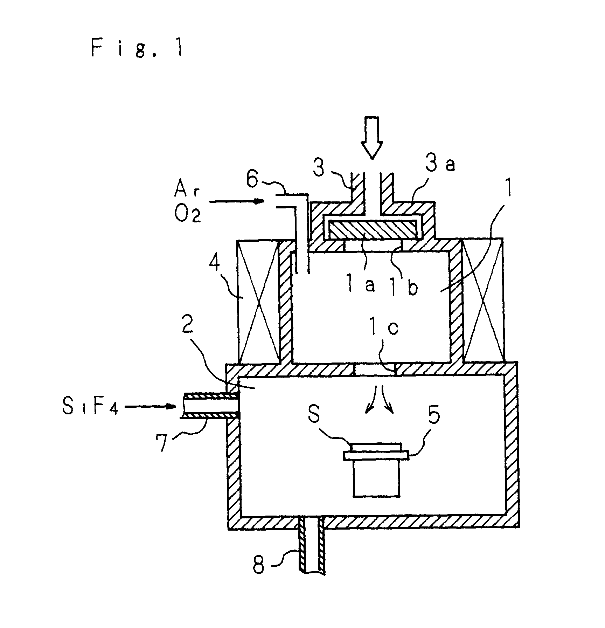

Fig. 1 is a schematic longitudinal section view showing the configuration of an ECR plasma CVD apparatus which is used in an execution of the invention. In the figure, numeral 1 designates a plasma chamber which has a hollow cylindrical shape. A microwave inlet lb having a circular shape is formed at the upper center portion of the chamber. A cylindrical waveguide 3 is connected at one end to a microwave oscillator which is not shown. The other end of the waveguide 3 is provided with a flange 3a, and connected to the microwave inlet 1b. A microwave introduction window la consisting of a quartz glass plate is formed in the microwave inlet 1b so as to close the microwave inlet lb. In the periphery of the plasma chamber 1, an exciting coil 4 is disposed in such a manner that it concentrically surrounds the plasma chamber 1 and the other end portion of the waveguide 3 connected to the chamber. The exciting coil 4 is connected to a DC power source which is not shown. A gas feeding system 6 opens on the upper wall of the plasma chamber 1.

A plasma extraction window lc is formed in the center portion of the lower wall of the plasma chamber 1 so as to oppose the microwave inlet 1b. In a reaction chamber 2 is a specimen table 5 located at a position which faces the plasma extraction window 1c. A specimen S is mounted on the specimen table 5. In the reaction chamber 2, a gas feeding system 7 opens on the side wall, and an exhaust system 8 on the lower wall. The exhaust system 8 is connected to an evacuation apparatus which is not shown.

In the apparatus having the above-described configuration, an Si oxide film can be formed on the specimen S in the following manner: At first, the specimen table 5 is heated to a temperature of 300 °C, and the plasma chamber 1 and the reaction chamber 2 are evacuated to a pressure of less than 1 × 10⁻⁶ Torr (1 Torr = 133·3 Pa) through the exhaust system 8. Then, 30 sccm of SiF₄ is supplied from the gas feeding system 7 into the reaction chamber 2, and 43 sccm of Ar and 70 sccm of O₂ are supplied from the gas feeding system 6 into the plasma chamber 1. Thereafter, the inside of the reaction chamber 2 is set to a predetermined pressure, for example, 2 × 10⁻³ Torr. A microwave of an output of 2.8 kW is introduced from the microwave oscillator which is not shown into the plasma chamber 1 through the waveguide 3 and the microwave introduction window la, and a magnetic field is generated in the plasma chamber 1 by the exciting coil 4, thereby satisfying the ECR conditions in the plasma chamber 1. Therefore, the Ar and O₂ gasses supplied into the plasma chamber 1 are decomposed and a plasma is generated. The generated plasma is introduced into the reaction chamber 2 by the magnetic field, and activates the SiF₄ gas so that an Si oxide film is formed on the surface of the specimen S.

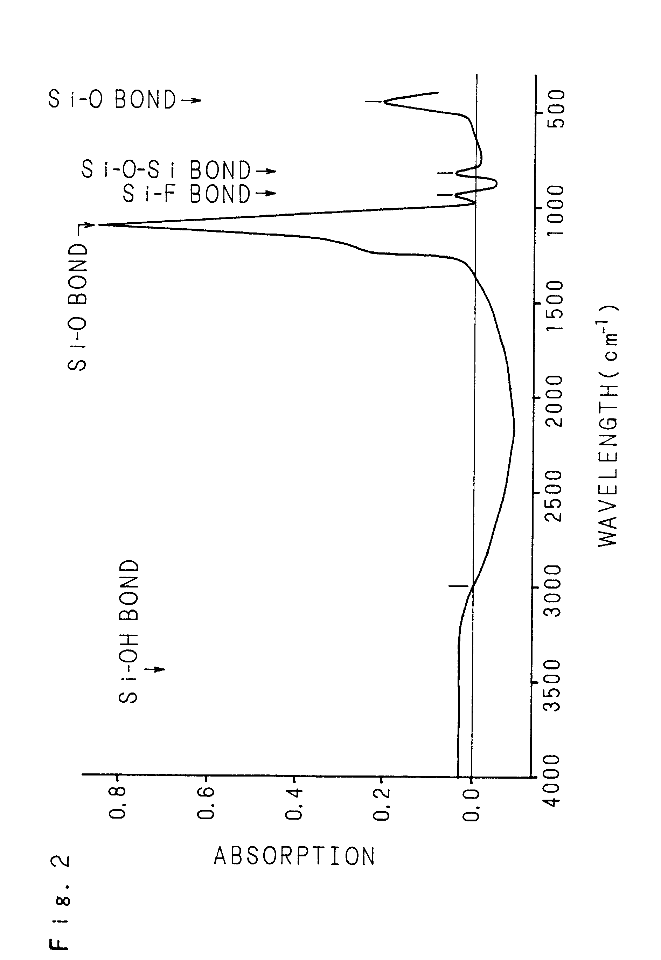

Next, a semiconductor device of a first embodiment which is produced by the aforementioned production method but does not form part of the claimed invention will be described. Fig. 2 shows the infrared absorption spectrum of the above-mentioned Si oxide film. As seen from the figure, an absorption due to the Si-F bond appears at 940 cm⁻¹, showing that fluorine is taken in the Si oxide film. It has been known that, in an Si oxide film formed by a conventional CVD, an absorption due to the Si-OH bond appears in the vicinity of 3,600 cm⁻¹. By contrast, in the Si oxide film according to the aforementioned embodiment, no absorption due to the Si-OH bond appears, showing that there is no OH in the Si oxide film.

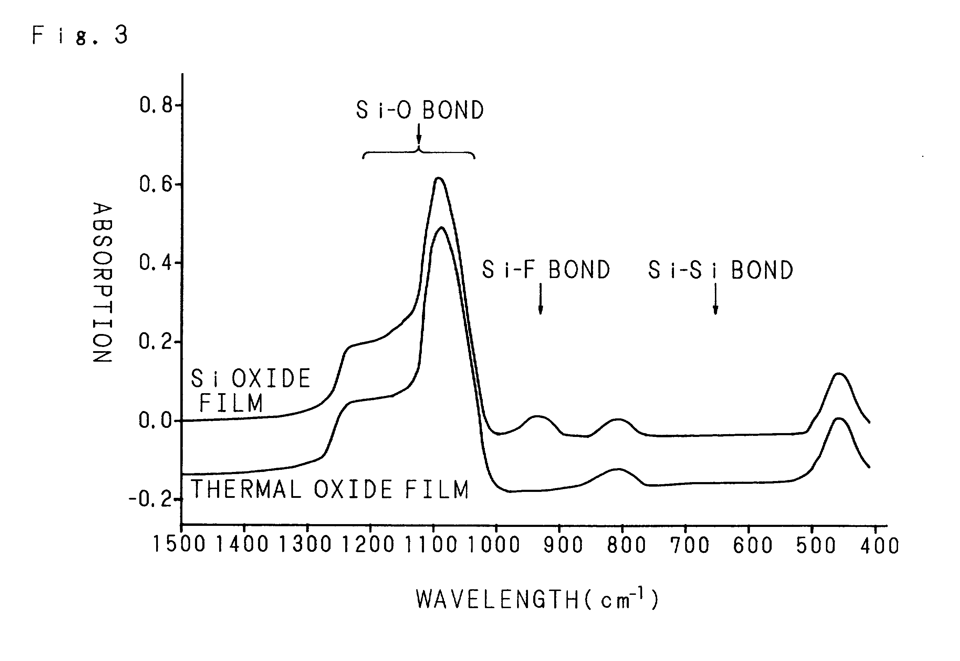

Fig. 3 shows the infrared absorption spectrum of the Si oxide film in the range of 400 cm⁻¹ to 1,500 cm⁻¹. In the figure, also an infrared absorption spectrum of a thermal oxide film is shown as a reference. The shape of the absorption spectrum due to the Si-O bond of the Si oxide film which appears in 1,000 cm⁻¹ to 1.300 cm⁻¹ is very similar to that of the thermal oxide film. This shows that, in the same manner as the thermal oxide film, the Si oxide film has stable Si-O bonds and an excellent film quality.

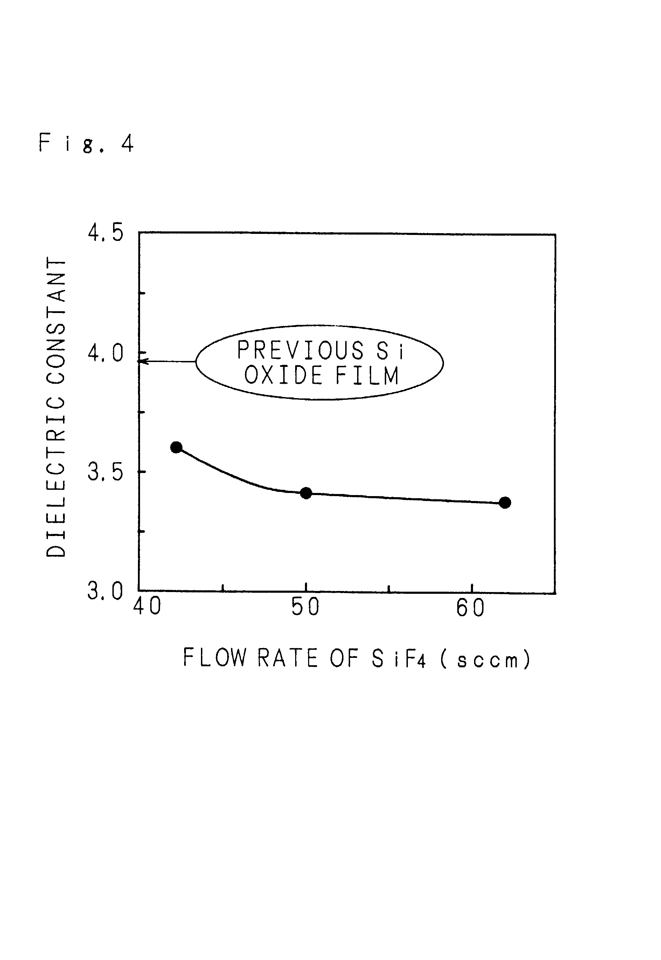

Fig. 4 is a graph showing the SiF₄ dependence of the dielectric constant of the Si oxide film which is produced by the method described above. In the graph, the axis of ordinate indicates the dielectric constant, and the axis of abscissa indicates the flow rate of SiF₄. It has been known that, in an Si oxide film which is formed by a CVD with the use of SiH₄ and O₂, the lower limit of the dielectric constant is 3.8 to 3.9. As seen from the graph, according to the embodiment, a dielectric constant of 3.3 to 3.6 is realized, or an Si oxide film having a low dielectric constant can be obtained.

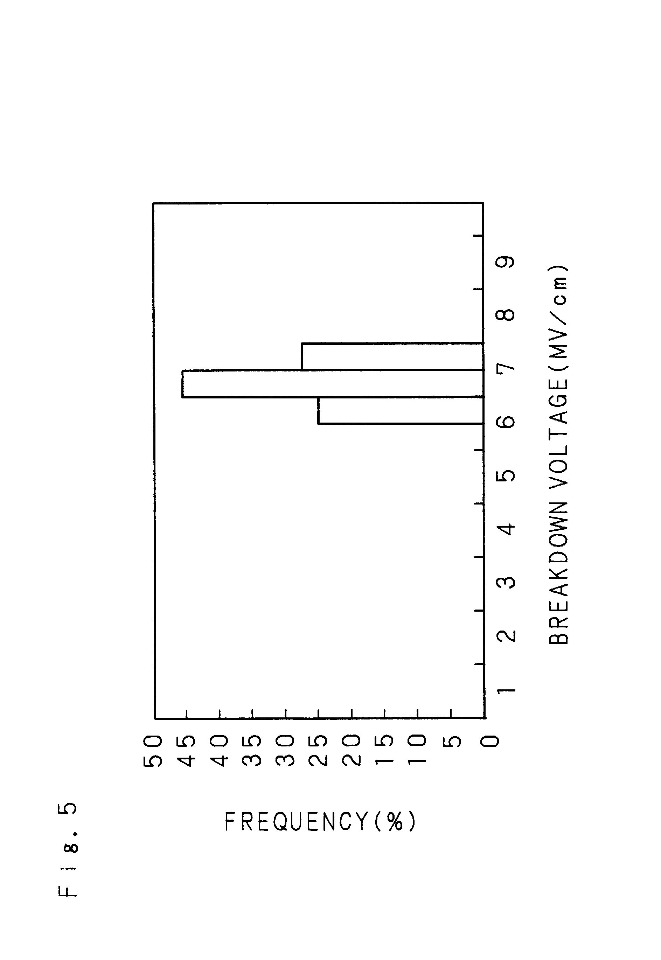

Fig. 5 is a graph showing the breakdown strength of the Si oxide film which is produced by the method described above. In the graph, the axis of abscissa indicates the breakdown voltage, and the axis of ordinate indicates the frequency. As seen from the graph, the breakdown voltage is distributed in the range of about 6.5 to 8.0 MV/cm. In other words, it can be said that the Si oxide film has excellent breakdown strength in the same manner as a conventional Si oxide film.

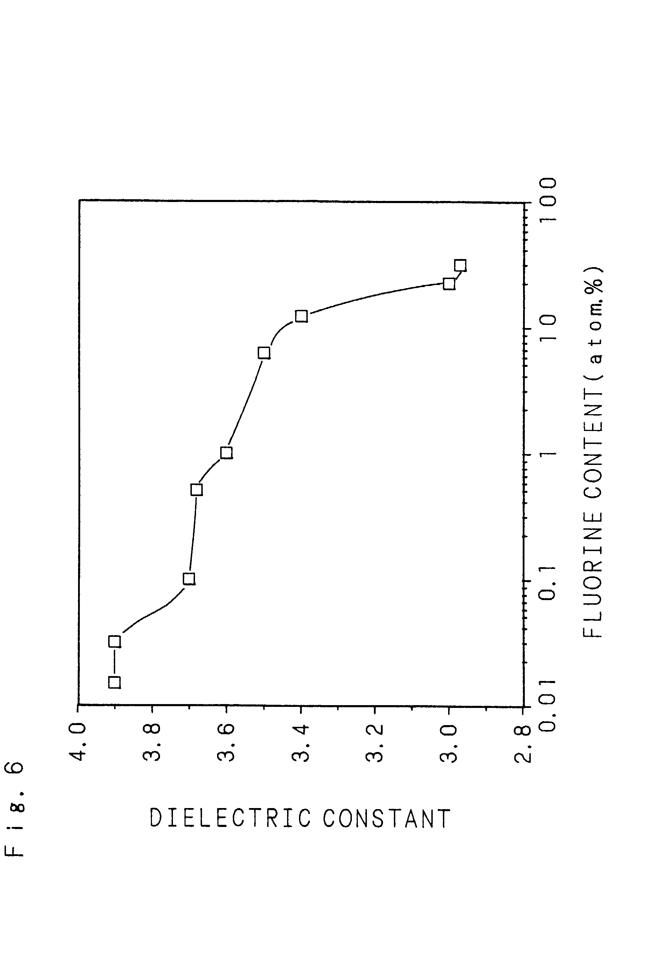

Next, an Si oxide film according to a second embodiment which is produced by a production method under conditions different from those of the embodiment described above and is also not covered by the invention will be described. A specimen S was placed in the reaction chamber 2 of the apparatus (Fig. 1) used in the embodiment described above, and, under the conditions where the microwave power and the O₂ flow rate were optimized, an Si oxide film was formed on the specimen S. Fig. 6 is a graph showing the dielectric constant with respect to the quantity of fluorine in the Si oxide film. In the graph, the axis of ordinate indicates the dielectric constant, and the axis of abscissa indicates the fluorine content. As the fluorine content changes from 0.01 atom.% to 0.1 atom.%, the dielectric constant decreases from 3.9 to 3.7, and, as the fluorine content further changes from 0.1 atom.% to 20 atom.%, the dielectric constant decreases from 3.7 to 2.9. It is impossible to distinguish an Si oxide film having the fluorine content of less than 0.1 atom.% from an Si oxide film produced by the prior art, on the basis of their characteristics.

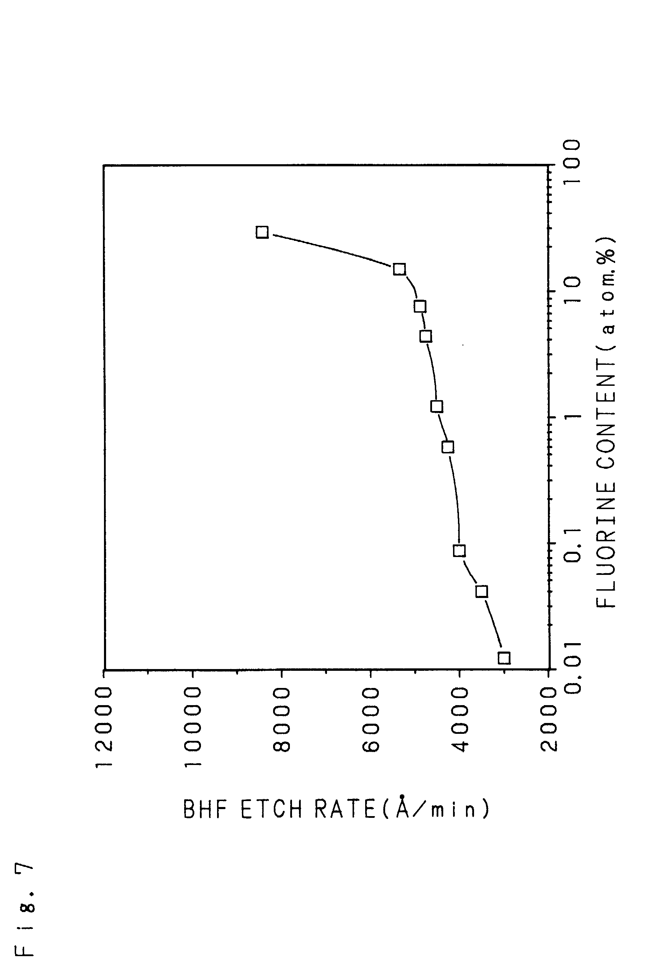

Fig. 7 is a graph showing the BHF etch rate with respect to the quantity of fluorine in the above-described Si oxide film. In the graph, the axis of ordinate indicates the BHF etch rate, and the axis of abscissa indicates the fluorine content. As the fluorine content changes from 0.01 atom.% to 20 atom.%, the BHF etch rate increases to 3,000 Å/min. to 4,800 Å/min. The BHF etch rate of an Si oxide film having a fluorine content of greater than 20 atom.% is larger than 8,000 Å/min. A fast etch rate indicates that the Si oxide film has a film quality of the porous state and the reliability as an insulating film is extremely lowered. From the above, it is difficult to use an Si oxide film having a fluorine content of less than 0.1 atom.% and that having a fluorine content of greater than 20 atom.%, as an interlayer dielectric film or a passivation film.

A third embodiment forming an example of the invention will be described specifically. In the embodiment described below, an Si oxide film is formed on a specimen S by an ECR plasma CVD apparatus. The apparatus is constructed in the same manner as that of Fig. 1, except that SiF₄ and SiH₄ are selectively introduced from the gas feeding system 7. The corresponding portions are designated by the same reference numerals, and their description is omitted. When an Si oxide film is to be formed on the specimen S by the apparatus, at first Ar and O₂ gasses are supplied from the gas feeding system 6 into the plasma chamber, and SiH₄ gas is supplied from the gas feeding system 7 into the reaction chamber 2, so that a plasma is generated to form an Si oxide film on the specimen S. When an Si oxide film of a thickness of 1,000 Å is formed, the oscillation of the microwave is stopped, and the gas supplied from the gas feeding system 7 is changed from SiH₄ to SiF₄. Then, a microwave is again introduced into the plasma chamber 1, and an Si oxide film is formed.

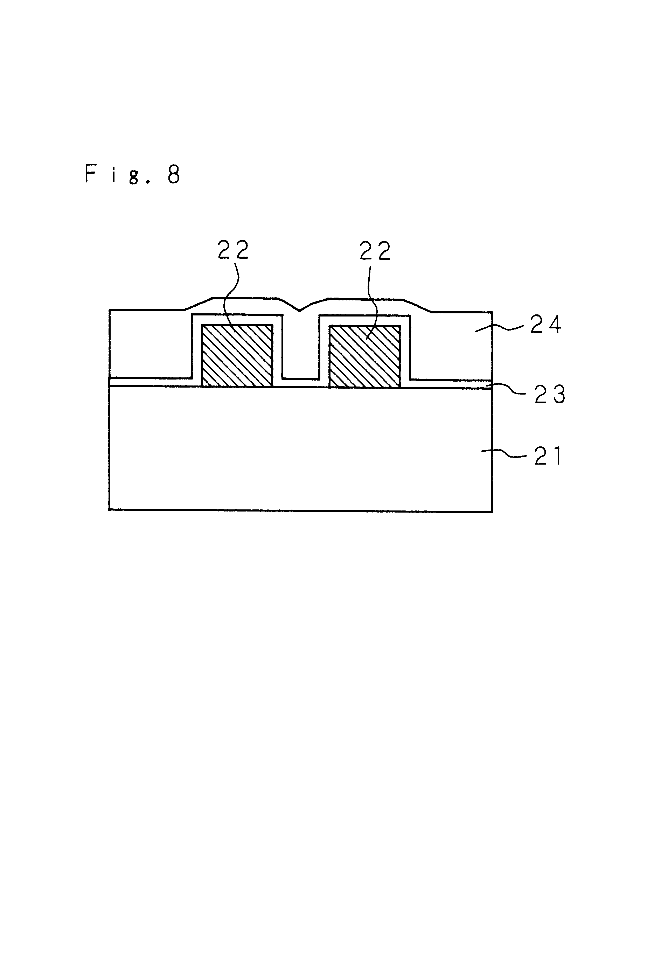

Fig. 8 is a schematic section view of an Si oxide film formed in the embodiment. A first Si oxide film 23 of surface of the specimen S where Al wirings 22, 22 are formed on a substrate 21. The first Si oxide film 23 is produced by the use of SiH₄ and does not contain fluorine. A second Si oxide film 24 is deposited on the Si oxide film 23 so as to make the surface substantially flat. The second Si oxide film 24 is produced by the use of SiF₄ and contain fluorine. Al, which is used as a wiring material in the embodiment, reacts with fluorine to form an insulator AlF₃. Therefore, it is not desirable to make SiF₄ gas contact with the specimen S on which the Al wirings 22, 22 are formed. In the embodiment, since the non-fluorine Si oxide film 23 due to SiH₄ is thinly deposited on the Al wirings 22, 22 an Si oxide film 24 due to SiF₄ can be formed without causing the Al wirings 22, 22 and SiF₄ to react with each other. It is all right that the Al wirings 22, 22 may be composed of an Al alloy.

A fourth embodiment partly forming an example of the invention will be described specifically with reference to the drawings illustrating the embodiment.

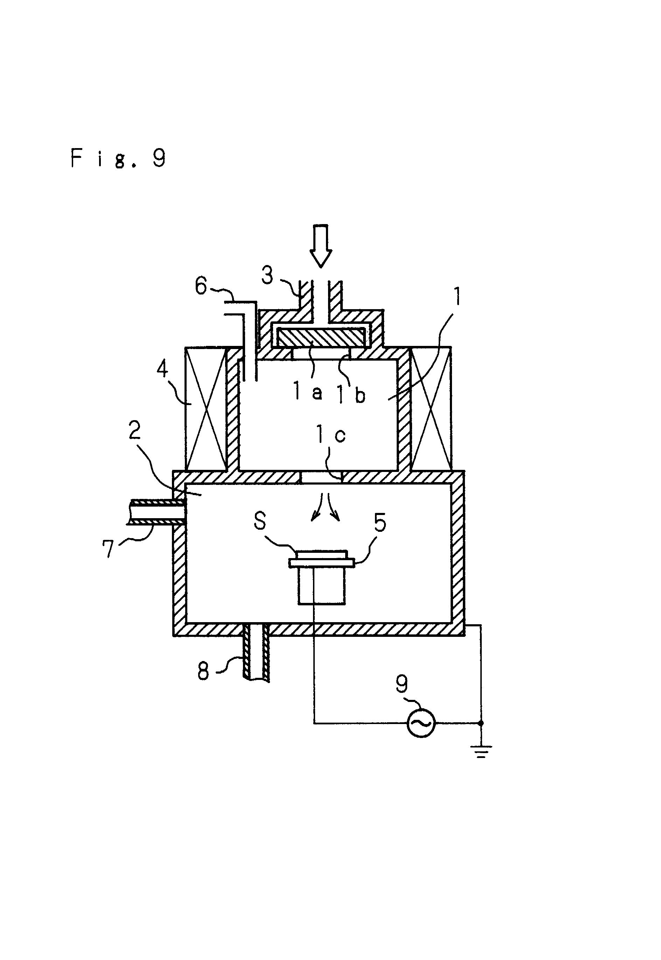

Fig. 9 is a schematic longitudinal section view showing the configuration of an ECR plasma CVD apparatus which is used in the execution of the production according to the fourth embodiment. In the figure, numeral 1 designates a plasma chamber, and 2 designates a reaction chamber. The apparatus is constructed in the same manner as that of Fig. 1, except that the specimen table 5 which is disposed in the reaction chamber 2 and on which the specimen S is mounted is connected to a high-frequency power source 9, thereby applying a bias voltage to the specimen S. The corresponding portions are designated by the same reference numerals, and their description is omitted.

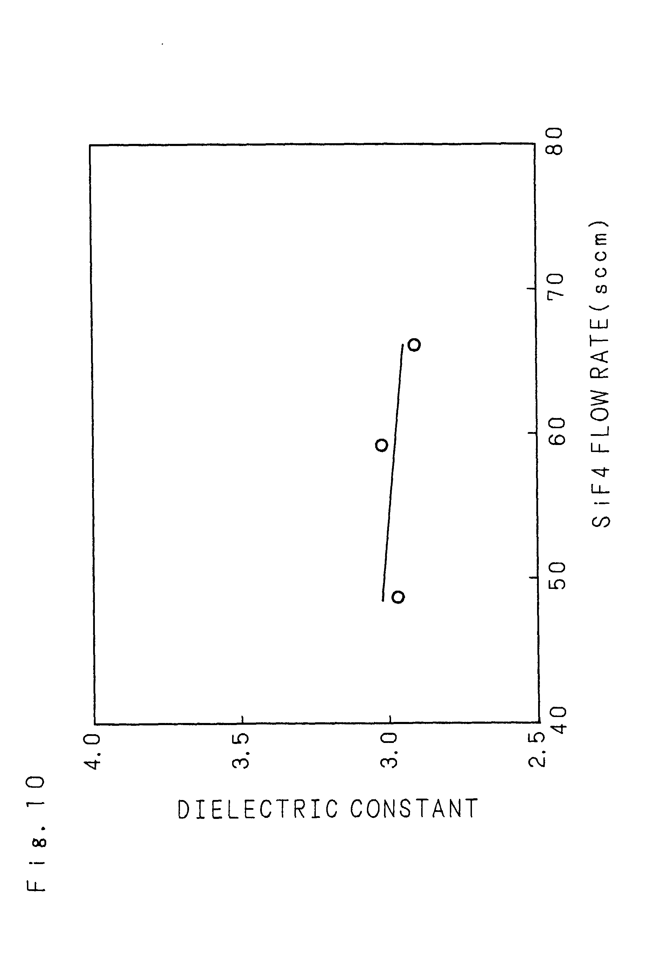

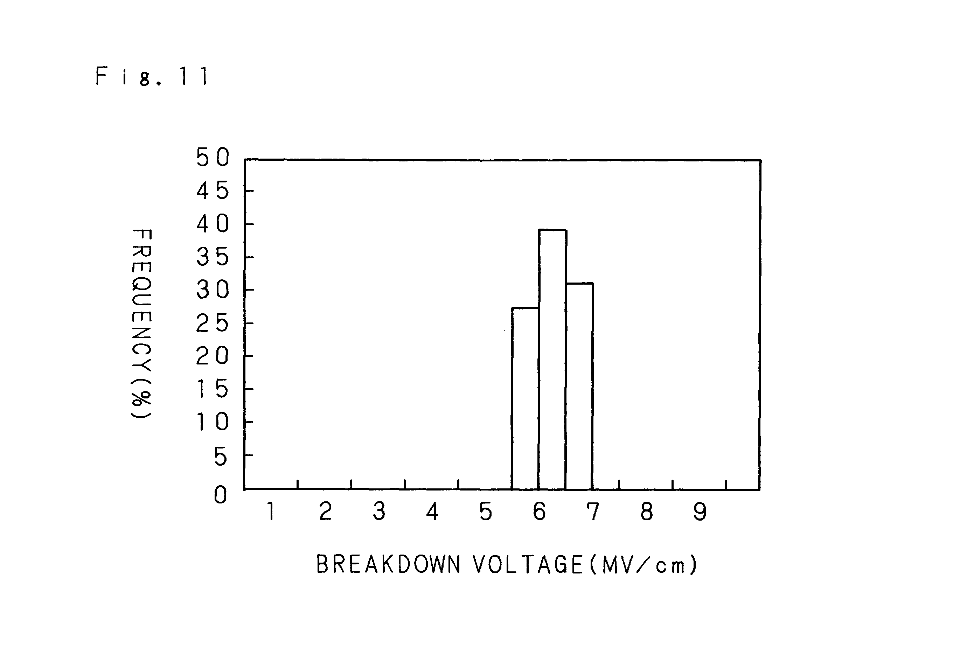

Fig. 10 is a graph showing the SiF₄ flow rate dependence of the dielectric constant of an Si oxide film produced by the apparatus. In the graph, the axis of ordinate indicates the dielectric constant, and the axis of abscissa indicates the SiF₄ flow rate. The film growth is conducted under the conditions that the flow rates of Ar and O₂ are 43 sccm and 70 sccm, respectively, the pressure is 2 x 10⁻³ Torr, the microwave power is 2.8 kW, the high-frequency electric power is 400 W, and the substrate temperature is 300° C. As seen from the graph, an Si oxide film having a very low dielectric constant of 2.9 to 3.0 can be obtained. Fig. 11 is a graph showing the breakdown strength of the Si oxide film. In the graph, the axis of ordinate indicates the frequency, and the axis of abscissa indicates the breakdown voltage. As seen from the graph, the breakdown voltage is distributed in the range of about 6.0 to 7.5 MV/cm. Namely, it can be said that the Si oxide film has an excellent breakdown strength in the same manner as a conventional Si oxide film.

Next a method according to the invention in which an Si oxide film is formed as an interlayer dielectric film on the specimen S having Al wirings thereon by the apparatus of Fig. 9 will be described. At first, Ar and O₂ gasses are supplied from the gas feeding system 6 into the plasma chamber 1, and SiH₄ gas is supplied from the gas feeding system 7 into the reaction chamber 2, so that a plasma is generated to form the above-mentioned Si oxide film of 1,000 Å thickness which does not contain fluorine on the specimen S. Thereafter, the oscillation of the microwave is stopped, and the gas supplied from the gas feeding system 7 is changed from SiH₄ to SiF₄. Then, a microwave is again introduced into the plasma chamber 1, and an Si oxide film containing fluorine is formed. In this method, the high-frequency power source 9 applies a negative bias voltage to the specimen S. This enables a sputter etching to be conducted on the specimen S simultaneously with the film growth.

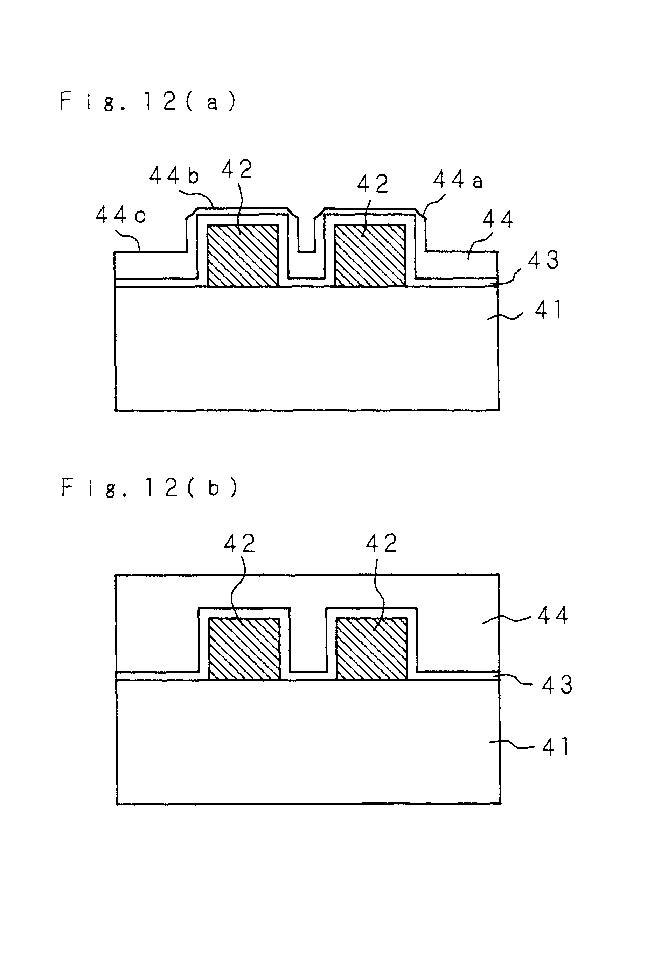

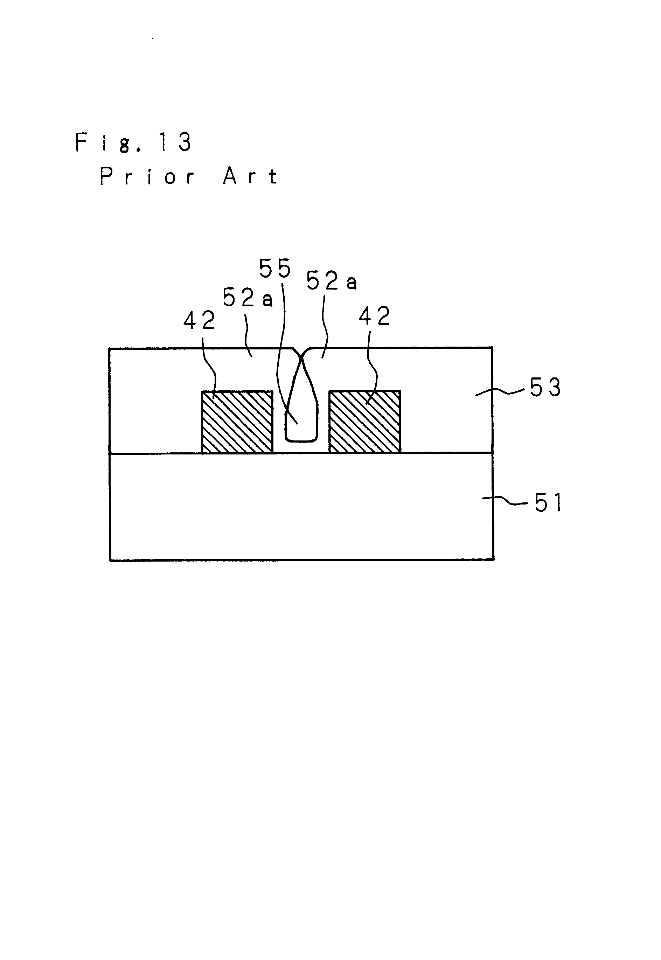

Figs. 12(a) and 12(b) are schematic section views of an Si oxide film formed in the embodiment, and Fig. 13 is a schematic section view of a conventional Si oxide film. As shown in Fig. 12(a), a non-fluorine Si oxide film 43 due to SiH₄ and having a thickness of 1,000 Å is formed on the surface of the specimen S where Al wirings 42, 42 are formed on a semiconductor substrate 41, and an Si oxide film 44 due to SiF₄ is deposited on the Si oxide film 43. In the sputter etching, since the etching efficiency of the edge portions 44a of the Si oxide film 44 due to SiF₄ is greater than that of the flat portion 44b, the edge portions 44a are partially removed away to form a taper shape. The etching efficiency of the flat portion 44c is smaller than that of the flat portion 44b. As the deposition of the Si oxide film 44 proceeds, therefore, the film growth rate of the flat portion 44c becomes substantially greater. Accordingly, as shown in Fig. 12(b), the Si oxide film 44 due to SiF₄ is deposited with an excellent planarity. The taper shape of the edge portions 44a allows the Si oxide film 44 to easily enter the space between the Al wirings 42, 42 whereby a defect such as a void is prevented from occurring. The Al wirings 22, 22 may be composed of an Al alloy.

Fig. 13 shows a conventional example in which an Si oxide film is formed on a specimen by a conventional CVD with the use of SiH₄. An Si oxide film 53 due to SiH₄ is deposited on the surfaces of Al wirings 42, 42 formed on a semiconductor substrate 51. As the film growth proceeds, the edge portions 52a, 52a deposited on the Al wirings 42, 42 become contacted with each other at their upper portions, and the Si oxide film 53 is made difficult to enter the space between the Al wirings 42, 42. When the film growth further proceeds, the upper portion of the space between the Al wirings 42, 42 is covered by the edge portions 52a, 52a to form a void 55. As described above, according to the embodiment, a semiconductor device having an Si oxide film of the improved planarizability can be produced.

A fifth embodiment partly forming an example of the invention will be described specifically with reference to the drawings illustrating the embodiment.

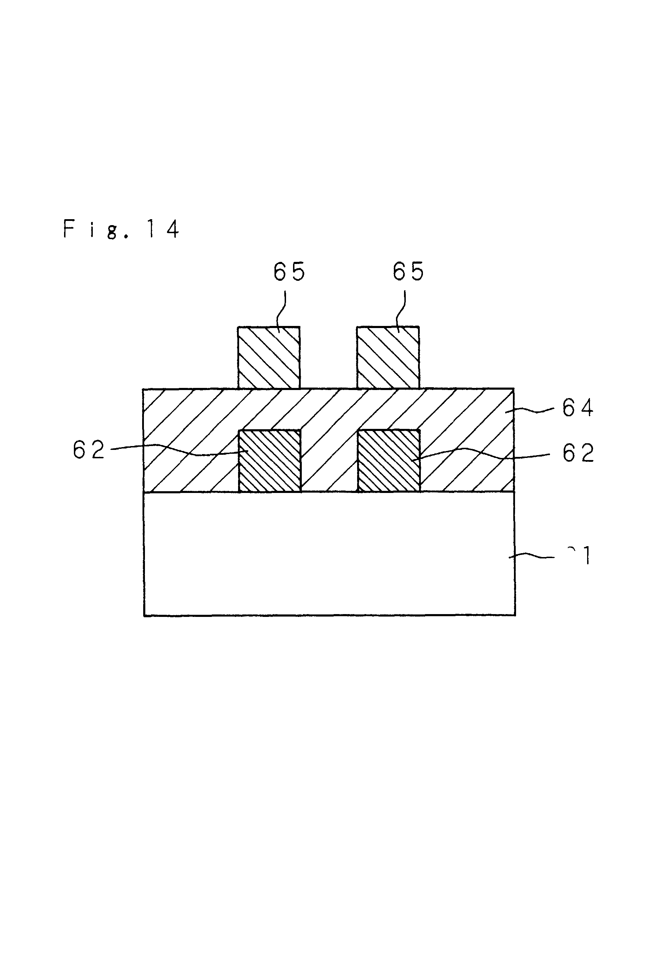

Fig. 14 is a schematic section view of a semiconductor device which is produced by a method of a fifth embodiment. In the apparatus of Fig. 9, Ar and O₂ gasses are supplied from the gas feeding system 6 into the plasma chamber 1, and SiF₄ gas is supplied from the gas feeding system 7 into the reaction chamber 2, so that a plasma is generated. Under this state, the high-frequency power source 9 applies a negative bias voltage to the specimen S, whereby an Si oxide film 64 is formed on the specimen S where Al wirings 62, 62 are formed on a semiconductor substrate 61. Then, Al wirings 65, 65 are formed on the Si oxide film 64.

As described above, an Si oxide film which is formed with the use of SiF₄ has a dielectric constant of 2.9 to 3.7. Therefore, the mutual interference noise between the Al wirings 62, 62 and the Al wirings 65, 65 is lowered in level, and the signal delay characteristic of the Al wirings 62, 62 and the Al wirings G5, 65 is improved.

When the capacity between wirings is set to be constant, a layer insulating Si oxide film having a dielectric constant of about 3.0 and formed according to the embodiment can be made smaller in thickness than that having a dielectric constant of about 4.0 and formed according to the prior art. In the case where a film thickness of 1 µm is required in the prior art, for example, the same capacity between wirings can be achieved by forming an Si oxide film containing fluorine in a thickness of 0.75 µm according to the invention. In this way, the use of an Si oxide film containing fluorine according to the invention allows the film thickness to be reduced while maintaining the capacity between wirings at the same level. This can reduce the aspect ratio of a via hole, which becomes large as the progress of the fine patterning technology.

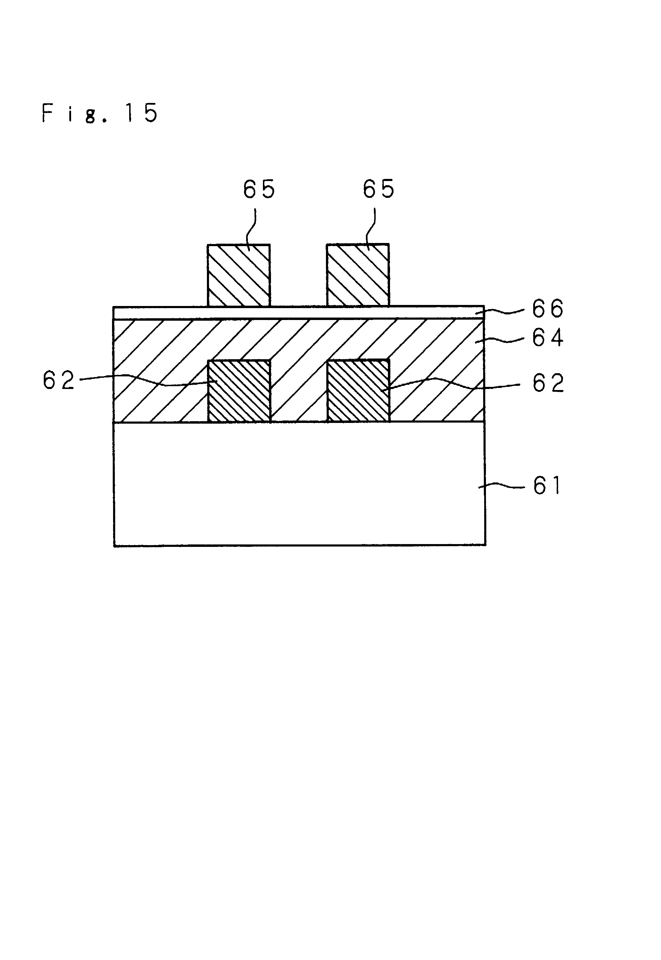

Fig. 15 is a schematic section view of another semiconductor device produced by the method of the fifth embodiment. In the apparatus of Fig. 9, Ar and O₂ gasses are supplied from the gas feeding system 6 into the plasma chamber 1, and SiF₄ gas is supplied from the gas feeding system 7 into the reaction chamber 2, so that a plasma is generated. Under this state, the high-frequency power source 9 applies a negative bias voltage to the specimen S, whereby the Si oxide film 64 is formed on the specimen S where the Al wirings 62, 62 are formed on the semiconductor substrate 61. Thereafter, the oscillation of the microwave is stopped, and the gas supplied from the gas feeding system 7 is changed from SiF₄ to SiH₄. then, a microwave is again introduced into the plasma chamber 1, and the above-mentioned non-fluorine Si oxide film 66 of 300 Å thickness is formed. Thereafter, the Al wirings 65, 65 are formed on the non-fluorine Si oxide film 66.

According to the method, during the formation of the Al wirings 65, 65 the degree of the contact between the Al wirings 65, 65 and a silicon compound gas containing fluorine, and that of the contact between the Al wirings 65, 65 and fluorine can be reduced so that the change of the crystal grain size and the corrosion of the Al wirings 65, 65 which may be caused by the contact are prevented from occurring. Since the non-fluorine Si oxide film 66 can be formed in a reduced thickness, it does not affect the space between the wirings, and therefore the mutual interference noise level is lowered and the signal delay characteristic is improved as compared with those of the prior art.

In the aforementioned production method, immediately after the completion of the formation of the Si oxide film 64 which functions as an interlayer dielectric film, the high-frequency electric power may be increased in level so that the sputtering yield of the surface is raised, thereby decreasing the number of fluorine atoms in the surface. Alternatively, immediately after the completion of the formation of the Si oxide film 64, a high-frequency bias voltage may be applied to the substrate while irradiating the substrate with a plasma of a nonreactive gas such as Ar gas, so that the sputtering is positively conducted, thereby decreasing the number of fluorine atoms in the surface. According to the alternatives, the prevention of the change in the crystal grain size and the corrosion of the Al wirings 65, 65 can be further enhanced.

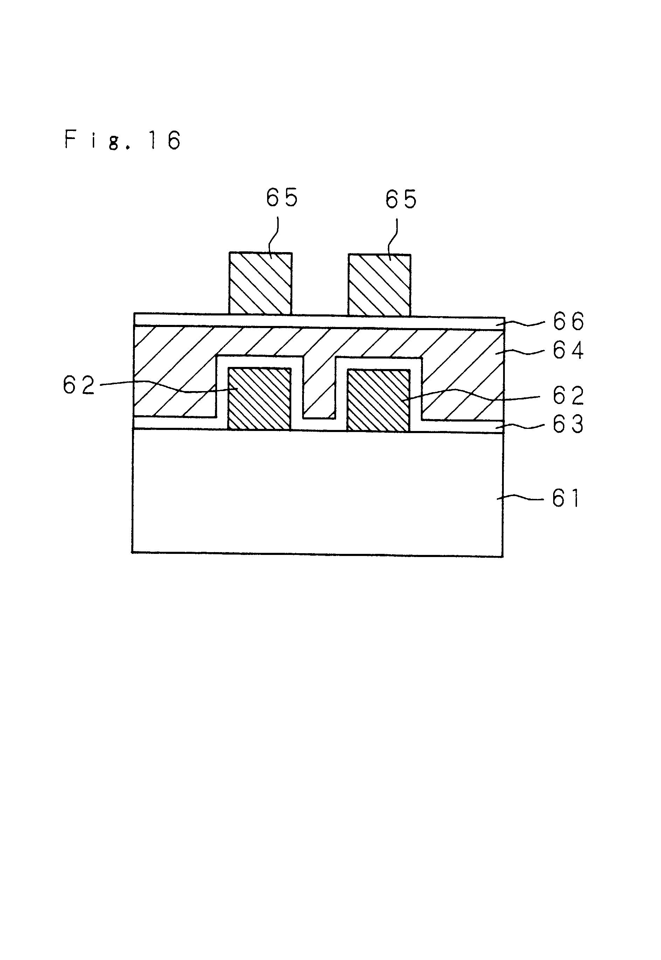

Fig. 16 is a schematic section view of a further semiconductor device produced by the method of the fifth embodiment and covered by the invention. In the apparatus of Fig. 9 a non-fluorine Si oxide film 63 is at first formed by a plasma CVD using SiH₄ on the specimen S where Al wirings 62, 62 are formed on the semiconductor substrate 61. Then, SiF₄ gas is supplied from the gas feeding system 7 into the reaction chamber 2, so that a plasma is generated. Under this state, the high-frequency power source 9 applies a negative bias voltage to the specimen S, whereby the second Si oxide film 64 containing fluorine is formed on the specimen S where the Al wirings 62, 62 are formed on the semiconductor substrate 61. Thereafter, the oscillation of the microwave is stopped, and the gas supplied from the gas feeding system 7 is changed from SiF₄ to SiH₄. Then, a microwave is again introduced into the plasma chamber 1, and the third Si oxide film 66 of 300 Å thickness which does not contain fluorine is formed. Thereafter, the Al wirings 65, 65 are formed on the nonfluorine Si oxide film 66. In the semiconductor device produced in this manner, the prevention of the corrosion of the Al wirings 62, 62 and 65, 65 which is due to fluorine can be further enhanced.

A sixth embodiment not covered by the invention will be described specifically with reference to the drawings illustrating the embodiment.

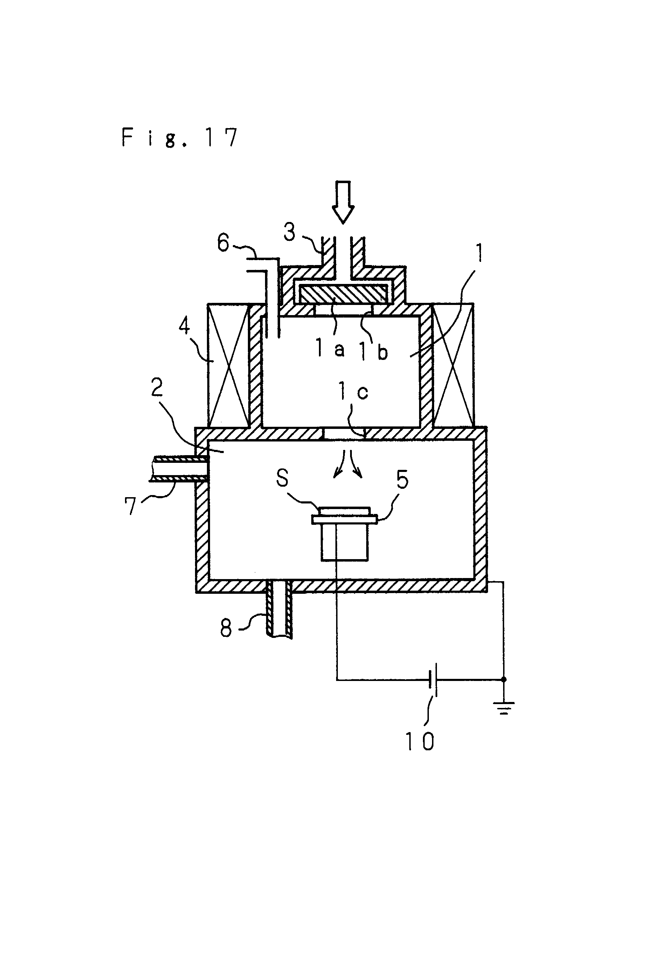

Fig. 17 is a schematic longitudinal section view showing the configuration of an ECR plasma CVD apparatus which is used in the execution of the production according to the sixth embodiment. In the figure 1 designates a plasma chamber, and 2 designates a reaction chamber. The apparatus is constructed in the same manner as that of Fig. 9, except that the specimen table 5 which is disposed in the reaction chamber 2 and on which the specimen S is mounted is connected to a DC power source 10, thereby applying a negative DC electric field to the specimen S, and that O₂ and N₂ are concurrently or selectively introduced from the gas feeding system 6 and SiF₄ and SiH₄ are concurrently or selectively introduced from the gas feeding system 7. The corresponding portions are designated by the same reference numerals, and their description is omitted.

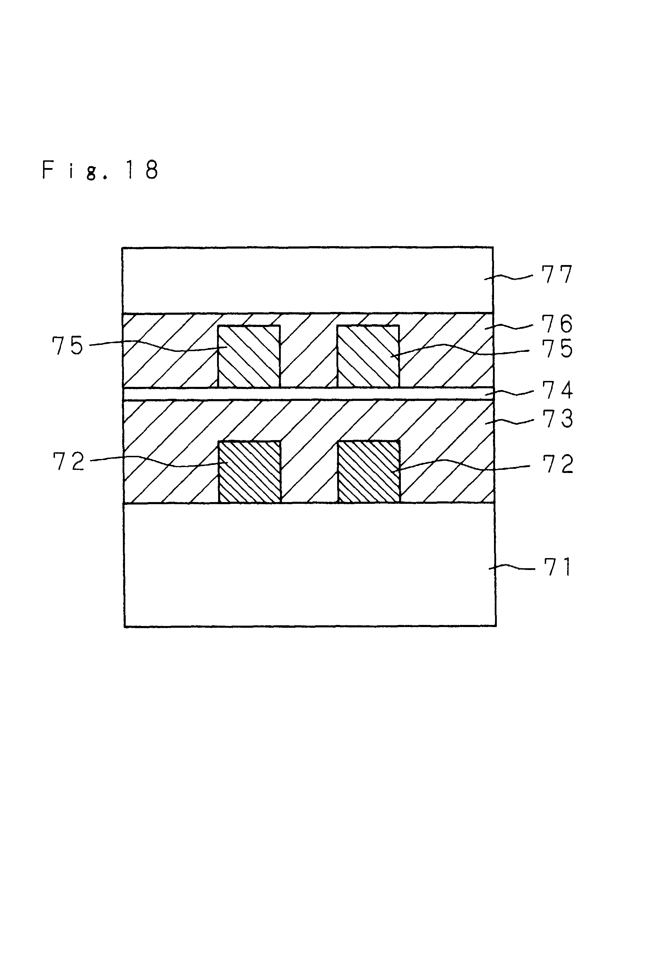

Fig. 18 is a schematic section view of a semiconductor device produced by a method of the sixth embodiment. In the apparatus described above, SiF₄ gas is introduced from the gas feeding system 7 into the reaction chamber 2 so that a plasma is generated, and a negative bias voltage is applied to the specimen S, whereby an Si oxide film 73 is formed on the specimen S where Al wirings 72, 72 are formed on a semicondutor substrate 71. Thereafter, the oscillation of the microwave is stopped, and the gas introduced from the gas feeding system 7 is changed from SiF₄ to SiH₄. Then, a microwave is again introduced into the plasma chamber 1, and the above-mentioned non-fluorine Si oxide film 74 of 300 Å thickness is formed. After uppermost Al wirings 75, 75 are formed on the non-fluorine Si oxide film 74, SiF₄ gas is again introduced to generate a plasma, and a negative bias voltage is applied to the specimen S, whereby an Si oxide film 76 is formed so as to bury the space between the Al wirings 75, 75 to flatten the surface. Thereafter, an Si nitride film 77 which functions as a passivation film is formed with the use of SiH₄ and N₂ gasses. In the formation of the Si nitride film 77, SiF₄ gas may be used in place of SiH₄ gas. Alternatively, in place of N₂ gas, N₂ and O₂ or N₂ and N₂O may be introduced so that the Si nitride film 77 is formed as an Si oxide and nitride film. The formation of the Si oxide and nitride film results in the formation of a passivation film of a further reduced stress.

In this way, an Si oxide film of a low dielectric constant is formed in the space between the uppermost Al wirings 75, 75 and an Si nitride film is formed thereon. In the prior art, the uppermost Al wirings 75, 75 are covered by an Si nitride film which functions as a passivation film, resulting in that an Si nitride film of a high dielectric constant (= 6.9) exists between the Al wirings 75, 75. The formation of the Si nitride film having a low dielectric constant in the embodiment can reduce the level of the mutual interference noise between the Al wirings 75, 75 and improve the signal delay characteristic. According to this embodiment, an Si oxide film of excellent characteristics can be formed and particles can be prevented from being produced.

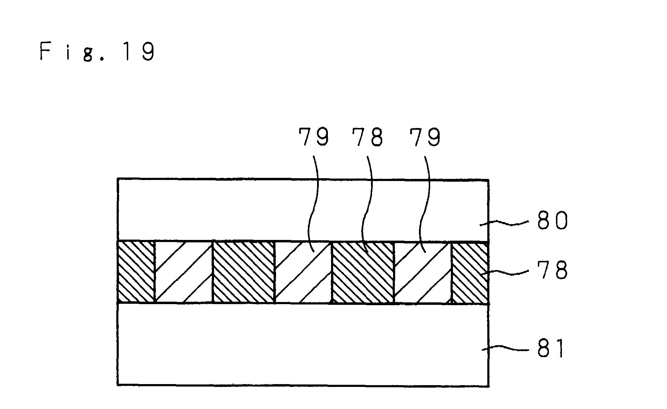

Fig. 19 is a schematic section view of a semiconductor device produced by a method of a seventh embodiment not covered by the invention. In the apparatus of Fig. 9, Ar and O₂ gasses are supplied from the gas feeding system 6 into the plasma chamber 1, and SiF₄ gas is supplied from the gas feeding system 7 into the reaction chamber 2, so that a plasma is generated. Under this state, the high-frequency power source 9 applies a negative bias voltage to the specimen S, whereby an Si oxide film 79 is formed on the specimen S where Al wirings 78, 78 are formed on an insulating film 81 which does not contain fluorine. At the time when the surface of the Si oxide film 79 becomes flush with the surfaces of the Al wirings 78, 78, the oscillation of the microwave is stopped, and the supplied gas is changed from SiF₄ to SiH₄. Then, a microwave is again introduced into the plasma chamber 1, and a nonfluorine Si oxide film 80 is formed on the Al wirings 78, 78 and the Si oxide film 79.

In this way, the Si oxide film 79 containing fluorine is formed only in the space between the Al wirings 78, 78, whereby the increase of the capacity between wirings in the same layer can be suppressed. This allows a seminconductor device which can be produced at the same cost as that of the prior art and can operate at a higher speed, to be formed by using the Si oxide film 79 containing fluorine only in the space between the wirings relating to a high speed operation of the semiconductor device, and using a conventional Si oxide film which does not contain fluorine in the other portion.

In the embodiment, insulating films which do not contain fluorine are used for the insulating film 81 and the Si oxide film 80 respectively formed below and above the Al wirings 78, 78 .... The insulating films may be conventional Si oxide films which are formed by a plasma CVD with the use of SiH₄, TEOS, or the like. In the case where the layer in which the Al wirings 78 are formed is the uppermost wiring layer, a passivation film such as an Si nitride is formed on the Al wirings 78, 78... and the Si oxide film 79.

The embodiment in which SiF₄ and O₂ are supplied has been described. The invention is not restricted to this. Alternatively, a silicon compound gas containing fluorine, and O₂ or N₂O may be used.

In the embodiments, the Al wirings 22, 22 may be Al alloy wirings.

In the embodiment, an ECR plasma CVD is employed as a plasma CVD. The invention is not restricted to this, and a microwave plasma CVD or an RF plasma CVD may be employed.

As described above, according to this invention, an Si oxide film is formed by a plasma CVD with the use of a silicon compound gas containing fluorine, and therefore the invention can achieve excellent effects such as that the generation of particles can be suppressed and therefore the quality of the produced device and the yield thereof are improved, that the planarizability of the Si oxide film can be improved, and that the signal transmission in a semiconductor device can be conducted at a high speed.

## Claims

1. A semiconductor device comprising Al wirings or Al alloy wirings (22, 42, 62) and at least one Si oxide film, characterized in that said at least one Si oxide film includes a first Si oxide film (23, 43, 63) which contains substantially no fluorine and is formed on the surface of said wirings (22, 42, 62), and
a second Si oxide film (24, 44, 64) which contains 0.1 to 20 atom % of fluorine formed on said first Si oxide film (23, 43, 63).

2. A semiconductor device according to claim 1, further comprising a third Si oxide film (66) which does not contain fluorine and is formed on said second Si oxide film (64), and
second Al wirings or Al alloy wirings (65) formed on said third Si oxide film (66).

3. A method of producing a semiconductor device according to claim 1, comprising the steps of
forming Al wirings and Al alloy wirings (22, 42, 62) and at least one Si oxide film,
characterized by the steps of:
forming a first Si oxide film (23, 43, 63) containing substantially no fluorine on the surface of said wirings with use of a silicon compound gas which does not contain fluorine, and a gas selected from the group consisting of O₂ and N₂O by plasma CVD, and
forming a second Si film (24, 44, 64) containing fluorine on said first Si oxide film with use of a silicon compound gas which contains fluorine, and a gas selected from the group consisting of O₂ and N₂O by plasma CVD.

4. A method according to claim 3, comprising the further steps of :
forming a third Si oxide film (66) which does not contain fluorine on said second Si oxide film with use of a silicon compound gas which does not contain fluorine, and a gas selected from the group consisting of O₂ and N₂O by plasma CVD, and forming second Al wirings or Al alloy wirings (65) on said third Si oxide film (66).

## Patentansprüche

1. Halbleiteranordnung mit Al-Anschlüssen oder Anschlüssen (22, 42, 62) aus einer Al-Legierung und mindestens einem Si-Oxidfilm,
**dadurch gekennzeichnet,**
daß der mindestens eine Si-Oxidfilm einen ersten Si-Oxidfilm (23, 43, 63) aufweist, der im wesentlichen kein Fluor enthält und auf der Oberfläche der Anschlüsse (22, 42, 62) ausgebildet ist, und
einen zweiten Si-Oxidfilm (24, 44, 64), der 0,1 bis 20 Atom-% Fluor enthält, und auf dem ersten Si-Oxidfilm (23, 43, 63) ausgebildet ist.

2. Halbleiteranordnung nach Anspruch 1, die ferner einen dritten Si-Oxidfilm (66) umfasst, der kein Fluor enthält und auf dem zweiten Si-Oxidfilm (64) ausgebildet ist, sowie
zweite Al-Anschlüsse oder Anschlüsse (65) aus Aluminiumlegierung, die auf dem dritten Si-Oxidfilm (66) ausgebildet sind.

3. Verfahren zur Herstellung einer Halbleiteranordnung nach Anspruch 1, mit den Schritten:
Ausbildung von Al-Anschlüssen und Anschlüssen ((22, 42, 62) aus einer Aluminiumlegierung und mindestens einem Si-Oxidfilm,
gekennzeichnet durch die Schritte:
Ausbildung eines ersten Si-Oxidfilms (23, 43, 63), der im wesentlichen kein Fluor enthält, auf der Oberfläche der Anschlüsse unter Verwendung eines Gases einer Siliziumverbindung, die kein Fluor enthält, und eines Gases, das aus der Gruppe ausgewählt ist, die aus O₂ und N₂O besteht, mittels Plasma-CVD und
Ausbildung eines zweiten Si-Oxidfilms (24, 44, 64), der Fluor enthält, auf dem ersten Si-Oxidfilm unter Verwendung eines Gases einer Siliziumverbindung, die Fluor enthält und eines Gases, das aus der Gruppe ausgewählt ist, die aus O₂ und N₂O besteht, mittels Plasma-CVD.

4. Verfahren nach Anspruch 3, mit den weiteren Schritten:
Ausbildung eines dritten Si-Oxidfilms (66), der kein Fluor enthält, auf dem zweiten Si-Oxidfilm unter Verwendung eines Gases einer Siliziumverbindung, die kein Fluor enthält, und eines Gases, das aus der Gruppe ausgewählt ist, die aus O₂ und N₂O besteht, mittels Plasma-CVD und Ausbildung zweiter Al-Anschlüsse oder Anschlüsse (65) aus Al-Legierung auf dem dritten Si-Oxidfilm (66).

## Revendications

1. Dispositif à semi-conducteur comprenant des fils en aluminium et des fils en alliage d'aluminium (22, 42, 62) et au moins un film d'oxyde de silicium, caractérisé en ce que ledit au moins un film d'oxyde de silicium comprend un premier film d'oxyde de silicium (23, 43, 63) qui, sensiblement, ne contient pas de fluor et est formé sur la surface desdits fils (22, 42, 62), et
un deuxième film d'oxyde de silicium (24, 44, 64) qui contient de 0,1 à 20 % atomiques de fluor formé sur ledit film d'oxyde de silicium (23, 43, 63).

2. Dispositif à semi-conducteur selon la revendication 1, comprenant en outre un troisième film d'oxyde de silicium (66) qui ne contient pas de fluor et qui est formé sur ledit second film d'oxyde de silicium (64), et
des seconds fils en aluminium ou en alliage d'aluminium (65) formés sur ledit troisième film d'oxyde de silicium (66).

3. Procédé pour fabriquer un dispositif à semi-conducteur selon la revendication 1, comprenant les étapes consistant à :
former des fils en aluminium et en alliage d'aluminium (22, 42, 62) et au moins un film d'oxyde de silicium, caractérisé par les étapes consistant à :
former un premier film d'oxyde de silicium (23, 43, 63) ne contenant sensiblement pas de fluor sur la surface desdits fils en utilisant un composé de silicium gazeux ne contenant pas de fluor, et un gaz choisi dans le groupe se composant de l'oxygène et de l'oxyde d'azote par procédé CVD au plasma, et
former un deuxième film d'oxyde de silicium (24, 44, 64) contenant du fluor sur ledit premier film d'oxyde de silicium en utilisant un composé de silicium gazeux ne contenant pas de fluor, et un gaz choisi dans le groupe se composant de l'oxygène et de l'oxyde d'azote par procédé CVD au plasma.

4. Procédé selon la revendication 3, comprenant en outre les étapes consistant à
former un troisième film d'oxyde de silicium (66) qui ne contient pas de fluor sur ledit second film d'oxyde de silicium en utilisant un composé de silicium gazeux qui ne contient pas de fluor, et un gaz choisi dans le groupe se composant de l'oxygène et de l'oxyde d'azote par procédé CVD au plasma, et à former des seconds fils d'aluminium ou en alliage d'aluminium (65) sur ledit troisième film d'oxyde de silicium (66).
